# EUROPÄISCHE PATENTSCHRIFT

(11) **EP 1 061 101 B1**
(45) Veröffentlichungstag und Bekanntmachung des Hinweises auf die Patenterteilung: **31.03.2004**
(21) Anmeldenummer: 00111915.5
(22) Anmeldetag: 14.06.2000
(51) Int. Cl.: C08L 63/00, C08G 59/68, C08L 71/02, C08L 67/00, C08L 69/00

(54) **Kationisch härtende Masse, ihre Verwendung sowie Verfahren zur Herstellung gehärteter Polymermassen**
Cationally hardenable compositions and polymers therefrom
Compositions durcissables cationiquement et leur polymères

(30) Priorität: 18.06.1999 DE 19927949
(43) Veröffentlichungstag der Anmeldung: 20.12.2000
(73) Patentinhaber: DELO Industrieklebstoffe GmbH & Co. KG, 86899 Landsberg (DE)
(72) Erfinder: Dengler, Dietmar, Dr., 86899 Landsberg (DE); Stumbeck, Michael, Dr., 86899 Landsberg (DE)
(74) Vertreter: Bunke, Holger, Dr.rer.nat. Dipl.-Chem.

(56) Entgegenhaltungen:
- EP-A- 0 764 691
- EP-A- 1 092 740
- US-A- 4 256 828
- US-A- 4 560 709
- US-A- 4 593 052
- US-A- 5 516 813

## Beschreibung

Die Erfindung betrifft kationisch härtende Polymermassen, die als Einkomponentenmassen mehrere Monate lang stabil gelagert werden können und mittels zweier unterschiedlicher Härtungsmechanismen, einem lichtinitiierten und einem wärmeinitiierten Härtungsmechanismus, ausgehärtet werden können.

Die Erfindung betrifft insbesondere solche kationisch härtenden Massen, die bei niedrigen Temperaturen in kurzer Zeit ausgehärtet werden können, aber gleichzeitig eine gute Lagerstabilität aufweisen, und die sich für das Verkleben, Vergießen, Abdichten und Beschichten von Substraten verwenden lassen.

Schließlich betrifft die Erfindung ein Verfahren zur Herstellung kationisch gehärteter Polymermassen aus den erfindungsgemäßen kationisch härtenden Massen.

Die lichtinitüerte kationische Polymerisation von Massen für das Verkleben, Vergießen und Abdichten ist seit langem bekannt. Die ausgehärteten Massen zeichnen sich durch hohe Kohäsion und ein sehr gutes Adhäsionsvermögen auf einer Vielzahl von Substraten aus. Die breite Einsatzfähigkeit der strahlungshärtenden Massen wird jedoch dadurch eingeschränkt, daß bei solchen Anwendungsfällen, bei denen die flüssigen Massen in Schattenzonen verlaufen oder abwandern können, keine Aushärtung in den für die Strahlung unzugänglichen, abgeschatteten Bereichen stattfindet. Es hat deshalb nicht an Versuchen gefehlt, die kationischen Massen mit einem zweiten Aushärtungsmechanismus zu versehen, der eine sichere Härtung auch in den abgeschatteten Bereichen gewährleistet.

So sind in EP-A-0 688 804 kationisch härtende Epoxidmassen beschrieben, die aus folgenden Bestandteilen bestehen:
(1) Kationisch polymerisierbare epoxidgruppenhaltige Monomere
(2) Lewis- oder Brönsted-Säuren und/oder Verbindungen, die unter Lichteinwirkung diese Säuren erzeugen sowie
(3) mindestens einem der weiteren Bestandteile Flexibilisierungsmittel, Verzögerer, radikalisch polymerisierbare Monomere, Beschleuniger und/oder Modifikatoren wie Farbstoffe, Pigmente, Füllstoffe, Verstärkungsmittel, Thixotropiermittel, Initiatoren, Stabilisatoren, Inhibitoren und Haftvermittler.

Diese bekannten Massen sind extrem reaktiv, so daß sie in Form eines Einkomponenten-Gemischs, also bei gleichzeitiger Anwesenheit der Bestandteile (1) bis (3), schon in Gegenwart von Tageslicht und bei Raumtemperatur extrem schnell aushärten und keinerlei Lagerstabilität haben würden. Deshalb müssen die Bestandteile dieser bekannten Massen auf mindestens zwei Komponenten in definierter Weise aufgeteilt und in dieser Mehrkomponentenform gelagert werden. Erst unmittelbar vor ihrer bestimmungsgemäßen Verwendung dürfen die zwei oder mehr Komponenten miteinander vermischt und dem Licht und/oder Wärme ausgesetzt werden, worauf sie extrem schnell aushärten. Eine Besonderheit dieser bekannten Massen besteht darin, daß eine der beiden Komponenten, die noch nicht sämtliche Bestandteile enthält, durch Bestrahlung mit Licht einer Wellenlänge von 280 bis 650 nm aktiviert werden kann und in dieser aktivierten Form bis zu 90 Tage lang stabil gelagert werden kann, wodurch nach dem Vereinigen der beiden oder gegebenenfalls mehreren Komponenten eine rasche Aushärtung der Massen auch in abgeschatteten Bereichen erfolgt.

Nachteilig an diesen bekannten Massen ist der hohe apparative Aufwand für eine dafür zwingend erforderliche Zwei- oder Mehrkomponenten-Mischanlage sowie der höhere Logistikaufwand für die getrennte Lagerhaltung von zwei oder mehr Komponenten.

Aus der EP-A-0 508 046 sind kationisch polymerisierbare Massen bekannt, die vor ihrer Applikation in einem Vorratsgefäß vollständig belichtet und damit aktiviert werden. Nachteilig ist dabei, daß das jeweils belichtete Volumen der Masse nicht vollständig aus dem Vorratsgefäß ausgebracht werden kann und daß das Gefäß von den Wänden her durch aushärtendes Material mehr oder weniger schnell zuwächst. Eine kontinuierliche Arbeitsweise ist hierbei nicht möglich.

Weitere aus dem Bereich der Klebetechnik bekannte Aushärteverfahren, z.B. anaerobe Härtung, Feuchtigkeitshärtung, aerobe Härtung, Härtung über Primer oder Aktivatoren, sind für die kationische Polymerisation nicht geeignet. In den meisten Druckschriften, die sich mit der kationischen Härtung von Polymermassen in lichtunzugänglichen Bereichen (Schattenzonen) befassen, werden deshalb Reaktionsmechanismen beschrieben, die auf einer wärmeinitiierten Härtung beruhen.

DE-A-197 05 027 und 196 38 630 beschreiben thermische Initiatoren für die kationische Polymerisation auf Basis von Thiolaniumsalzen, die jedoch lange Aushärtezeiten bei hoher Temperatur erfordern, beispielsweise 16 Stunden bei 130 °C oder 6 Stunden bei 140 °C oder 3 Stunden bei 150 °C. Nachteilig sind außerdem die schlechte Verfügbarkeit und der hohe Preis der Thiolaniumsalze.

DE-A-30 07 684 und 28 53 886 offenbaren wärmehärtbare Zusammensetzungen, die neben kationisch polymerisierbarem Material und Diaryliodoniumsalz ein Kupferchelat, gegebenenfalls zusammen mit einem Reduktionsmittel, oder organische Säuren oder Anhydride zur kationischen Warmhärtung enthalten. Nachteilig sind auch hier die lange Aushärtungszeit und die schlechte Lagerstabilität der beschriebenen Massen sowie die Toxizität der eingesetzten Kupferverbindungen, die blaugrüne Farbe, die schlechte Löslichkeit und der autokatalytische Effekt dieser Kupferverbindungen in bezug auf die lichtinduzierte Zersetzung von Polymeren.

Aus EP-A-0 146 501 sind Massen bekannt, die aromatische Iodosylsalze und als Cokatalysatoren Metallsalze und/oder Peroxide enthalten. Nachteile dieser Massen sind hohe Aushärtetemperaturen, schlechte Verfügbarkeit der aromatischen Iodosylsalze und die Toxizität der eingesetzten Metallsalze.

Schließlich sind aus der GB-A-2 070 616 kationisch polymersierbare Massen auf Basis von Diaryliodoniumsalzen bekannt, die über Dibenzylverbindungen oder oligomere Silylether einen thermischen Härtungsmechanismus erhalten. Nachteile dieser Massen sind hohe Aushärtetemperaturen von 140 bzw. 160 °C sowie eine nur unvollständige Umsetzung der kationisch polymerisierbaren Gruppen.

Aus dem US-Patent 4 374 751 sind kationisch härtende Epoxidmassen bekannt, die bestehen aus
(1) einer mindestens difunktionellen kationisch polymerisierbaren Epoxyverbindung
(2) einem Photoinitiator für die kationische Härtung auf Basis von Diaryliodoniumsalzen
(3) einer Peroxidverbindung, die bei Erwärmung Radikale freisetzt und
(4) ggf. Hilfs- und Zusatzstoffen wie z.B. Füllstoffen, Farbstoffen, Pigmenten und Mitteln zur Viskositätseinstellung.

Diese bekannten Massen sind unter Normalbedingungen lagerstabil und härten erst nach thermischer Aktivierung bei Temperaturen über 100 °C, vorzugsweise bei 150 °C, relativ langsam aus (gem. Beispiel 1 innerhalb von 3,5 Stdn. bei 150 °C).

Der Erfindung liegt die Aufgabe zugrunde, neue kationisch härtbare Massen vorzuschlagen, die als Einkomponenten-Massen mehrere Monate lang stabil gelagert und verarbeitet werden können, die lichtinduziert und/oder wärmeinduziert rasch und bei niedrigen Temperaturen vollständig ausgehärtet werden können und die auch in strahlungsunzugänglichen Schattenzonen unter schonenden Bedingungen ohne besonderen apparativen Aufwand ausgehärtet werden können. Die Massen sollen sich insbesondere zum Verkleben hitzeempfindlicher elektronischer Bauteile beim Bestücken von Leiterplatten (surface mounted devices) eignen.

Diese Aufgabe wird erfindungsgemäß gelöst durch die kationisch härtende Masse des Patentanspruchs 1; diese Masse besteht aus:
(A) 5 - 90 Masseteilen mindestens einer difunktionellen, kationisch polymerisierbaren Verbindung
(B) 0,01 - 5 Masseteilen eines Photoinitiators für die kationische Härtung auf Basis von Diaryliodoniumsalzen
(C) 0,1 - 70 Masseteilen von mindestens einer hydroxylgruppenhaltigen Verbindung mit einer Molmasse von 150 bis 10.000 g/mol und Hydroxy-Äquivalentmassen von 50 bis 5.000 g/mol
(D) 0,01 - 10 Masseteilen einer bei Erwärmung Radikale freisetzenden Verbindung mit einer Halbwertszeit von einer Stunde bei einer Temperatur von weniger als 100°C
(E) 0,001 - 10 Masseteilen eines Radikale bildenden Photoinitiators oder eines Photosensibilisierungsmittels für Diaryliodoniumsalze
(F) 0 - 60 Masseteilen von Modifikatoren, ausgewählt aus min- destens einer der Gruppen der Füllstoffe, Farbstoffe, Pigmente, Stabilisatoren, Beschleuniger, Verzögerer, Initiatoren, Fließverbesserer, Thixotropiermittel, Verdünnungsmittel und polymeren Verdickungsmittel,
wobei die Summe aller Masseteile 100 beträgt und sämtliche Bestandteile (A) bis (F) der kationisch härtenden Masse in Form eines lagerstabilen Einkomponenten-Gemischs vorliegen und wobei die kationisch härtende Masse lichtinitiiert und/oder wärmeinitiiert vollständig aushärtbar ist.

Bevorzugte Ausführungsformen der erfindungsgemäßen Masse sind zusätzlich durch die Merkmale der Patentansprüche 2 bis 9 gekennzeichnet.

Gegenstand der Erfindung ist außerdem die Verwendung der erfindungsgemäßen, kationisch härtenden Massen für das Verkleben, Vergießen, Abdichten und Beschichten von Substraten, insbesondere von elektronischen Bauteilen, mit denen Leiterplatten bestückt werden, wobei die Aushärtung der Klebermasse vorzugsweise erst nach dem Bestücken bzw. Fügen erfolgt, und zwar sowohl in den für Strahlung zugänglichen Bereichen als auch in den Schattenzonen, insbesondere unterhalb der aufgesetzten Bauteile.

Gegenstand der Erfindung ist ferner ein Verfahren zur Herstellung kationisch gehärteter Polymermassen, bei dem eine kationisch härtende Einkomponenten-Masse gemäß der Erfindung unter der Einwirkung einer Wellenlänge von 200 - 600 nm und/oder unter Wärmezufuhr, wobei die kationisch härtende Masse auf höchstens 120 °C erwärmt wird, gehärtet wird.

Als mindestens difunktionelle, kationisch polymerisierbare Verbindung (Bestandteil (A)) der erfindungsgemäßen Massen eignen sich Harze oder kationisch polymerisierbare Monomere wie z.B. polyfunktionelle Vinylether und Vinylester. Geeignete Vinylether sind Trimethylolpropan-Trivinylether, Ethylenglykol-Divinylether und cyclische Vinylether. Allgemein gut geeignete Verbindungen sind die Vinylester und Vinylether polyfunktioneller Alkohole, wobei Polyethylen- und Polypropylenglykole mit Vinylether-Endgruppen bevorzugt eingesetzt werden. Gut geeignet sind außerdem kationisch polymerisierbare heterocyclische Verbindungen wie z.B. die Glycidylether und β-Methylglycidylether cycloaliphatischer Diole und Polyole. Als Glycidylverbindungen sind außerdem die Glycidylester von Carbonsäuren, insbesondere von Di- und Polycarbonsäuren verwendbar, beispielsweise die Glycidylester von Bernsteinsäure, Adipinsäure und Phthalsäure. Beispiele für besonderes reaktive Glycidylverbindungen sind die Diepoxide des Vinylcyclohexans und des Dicyclopentadiens sowie 3-(3',4'-Epoxycyclohexyl)-8,9-epoxy-2,4-dioxyspiro(5.5)undecan und 3,4-Epoxycyclohexylmethyl-3',4'-epoxycyclohexylcarboxylat. Bevorzugte Epoxidharze sind gegebenenfalls vorverlängerte und/oder prepolymere Diglycidylether zweiwertiger Phenole oder zweiwertiger aliphatischer Alkohole mit zwei bis vier C-Atomen. Erfindungsgemäß können auch Mischungen verschiedener kationisch polymerisierbarer Verbindungen eingesetzt werden.

Als Diaryliodoniumsalze (Bestandteil (B)) können erfindungsgemäß die Salze der Formel

**[(Ar**^{**1**}**)(Ar**^{**2**}**)I]**^{**+**}**[MX**_{**n**}**]**^{**-**}

eingesetzt werden, worin Ar¹ und Ar², die gleich oder verschieden sein können, für aromatische Reste stehen, die gegebenenfalls unterschiedlich substituiert sein können, wie z.B. Phenyl, Naphthyl, Alkylphenyl und Halogenphenyl, oder worin Ar¹ und Ar² zusammen einen divalenten Rest der Formel 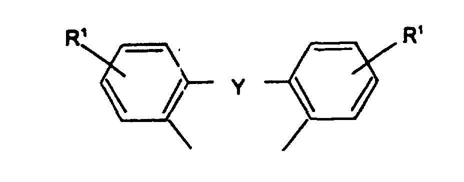 bedeuten, worin
R1, jeweils unabhängig voneinander, eine Alkyl- oder Alkoxygruppe mit 1 bis 4 C-Atomen, eine Nitrogruppe oder ein Halogenatom
Y ein Sauerstoff- oder Schwefelatom oder eine Methylengruppe
M eines der Elemente B, P, As, Sb, Sn oder Bi
X Fluor, Chlor oder Pentafluorphenyl bedeuten und
n = 4, 5 oder 6, dabei aber um 1 höher als die Valenz des Elements M
ist.

Vorzugsweise enthält das Diaryliodoniumsalz ein Anion mit einer geringeren Nucleophilie als SbF₆⁻, besonders bevorzugt enthält es Tetrakispentafluorophenylborat als Anion.

Besonders bevorzugt als Bestandteil (B) der erfindungsgemäßen Massen ist 4-Methylphenyl[4-(1-methylethyl)phenyl]iodonium-tetrakispentafluorophenylborat.

Als hydroxylgruppenhaltige Verbindung (Bestandteil (C)) können Polyesterpolyole, Polybutadiendiole und alkoxyverlängerte Hydroxyaromaten eingesetzt werden, und zwar jeweils mit Molmassen von 150 bis 10.000 g/mol, vorzugsweise von zwischen 1.000 und 5.000 g/mol, und Hydroxyl-Äquivalentmassen von 50 bis 5.000 g/mol, vorzugsweise von 500 bis 2.000 g/mol.

Die Polyesterpolyole können beispielsweise durch Polykondensation aus niedermolekularen Polyolen und Polycarbonsäuren bzw. deren Anhydriden hergestellt werden. Typische Vertreter dieser Verbindungsklasse sind im Handel unter der Bezeichnung "Dynacoll" erhältlich (Hersteller: Hüls).

Polyesterpolyole, die durch katalysierte Reaktionen von Caprolacton mit unterschiedlichen Starteralkoholen zugänglich sind, können ebenfalls verwendet werden. Typische Vertreter dieser Verbindungsklasse sind im Handel unter der Bezeichnung "Tone" (Hersteller: UCC) oder unter der Bezeichnung "Placcel" (Hersteller: Daicel) erhältlich.

Vorzugsweise werden als Polyesterpolyole Polycaprolactontriole mit Molmassen von 200 bis 2.000 g/mol und Polycaprolactondiole mit Molmassen von 300 bis 2.000 g/mol verwendet.

Die Verwendung von Polycarbonatpolyolen als Bestandteil (C) führt zu ausgehärteten Massen mit verringerter Wasseraufnahmefähigkeit.

Vorzugsweise werden Polycarbonatdiole mit Molmassen von 400 bis 2.000 g/mol der allgemeinen Formel 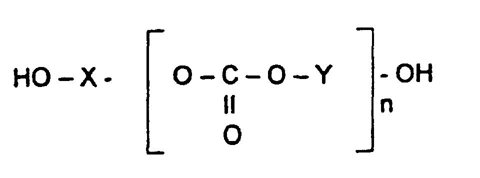 eingesetzt, worin X und Y, die gleich oder verschieden sein können, unabhängig voneinander Alkylen, Arylen, Alkarylen, Aralkylen oder Polyoxyalkylen bedeuten und n einen Wert zwischen 1 und 50, vorzugsweise zwischen 1 und 20, besitzt.

Die als Bestandteil (C) verwendbaren Polybutadiendiole stellen Homopolymerisate des Butadiens dar, die mit OH-Gruppen terminiert sind, Molmassen von 500 bis 5.000 g/mol aufweisen und einen hohen Gehalt an Doppelbindungen mit einer von den Herstellungsbedingungen abhängigen Verteilung zwischen trans-Vinylen-, cis-Vinylen- und Vinylgruppen besitzen. Typische Vertreter dieser Verbindungsklasse sind im Handel unter der Bezeichnung "Poly bd" (Hersteller: Atochem) erhältlich. Durch partielle Epoxidierung der Doppelbindungen und bevorzugt der Vinylgruppen sind Polybutadiendiole zugänglich, die mittelständige aliphatische Epoxygruppen und Epoxy-Äquivalentmassen von 200 bis 1.000 g/mol, vorzugsweise von 250 bis 600 g/mol, besitzen.

Als alkoxyverlängerte Hydroxyaromaten können ethoxy- oder propoxyverlängerte Bisphenole wie Bisphenol A oder Bisphenol F, Dihydroxynaphthaline oder Dihydroxybenzole eingesetzt werden. Typische Vertreter dieser Verbindungsklasse sind im Handel unter der Bezeichnung "Dianol" (Hersteller: AKZO) erhältlich.

Für die Einstellung des Eigenschaftsbildes der erfindungsgemäßen Massen kann es zweckmäßig sein, Polyole unterschiedlicher mittlerer Molmasse und unterschiedlicher Struktur für die Flexibilisierung einzusetzen; auf diese Weise können beispielsweise der Grad der Flexibilisierung, die Reaktivität, die Viskosität und das Anfließverhalten eingestellt werden.

Als Verbindungen, die bei Erwärmung Radikale freisetzen (Bestandteil (D)), müssen aus den dem Fachmann an sich bekannten Verbindungen solche verwendet werden, die eine Halbwertszeit von einer Stunde bei einer Temperatur von weniger als 100 °C, vorzugsweise von weniger als 80 °C, besitzen, damit die für technische Anwendungen der erfindungsgemäßen Massen geforderten kurzen Aushärtezeiten und niedrigen Aushärtetemperaturen erzielt werden. Unter "Halbwertszeit" ist die Zeit zu verstehen, in der bei einer bestimmten Temperatur die Hälfte der ursprünglichen Menge an Verbindung, welche bei Erwärmung Radikale freisetzt, zerfallen ist. Solche Verbindungen sind z.B. Azoverbindungen, Persäureester oder Peroxide. Bevorzugt werden Peroxide bzw. Peroxoverbindungen, wie z.B. Diarylperoxide, Peroxydicarbonate, Alkylperester, Perketale, Dialkylperoxide, Hydroperoxide oder anorganische Peroxide. Bevorzugt werden Alkylperester, beispielsweise tertiär-Butylperoxyneodecanoat, verwendet. Typische Vertreter dieser Peroxide sind im Handel unter der Bezeichnung "Interox" (Hersteller: Peroxid-Chemie GmbH) oder unter der Bezeichnung "Peroxan" (Hersteller: Pergan GmbH) erhältlich. Die Menge der bei Erwärmung Radikale freisetzenden Verbindung(en) beträgt vorzugsweise 0,01 - 10 Gew.-%, besonders bevorzugt 0,1 - 3,0 Gew.-%, jeweils bezogen auf die Gesamtmasse.

Der Bestandteil (E), also Photoinitiatoren für die radikalische Polymerisation oder Photosensibilisierungsmittel für Diaryliodoniumsalze, ermöglicht es, die ansonsten photochemisch nur mit UVC-Strahlung (200 - 280 nm) aushärtenden Massen auch mit längerwelligem Licht auszuhärten. Hierfür sind alle Verbindungen geeignet, die unter Einwirkung elektromagnetischer Strahlung entsprechender Wellenlänge Radikale nach einer Reaktion vom Typ Norrish I oder Norrish II bilden. Als Beispiele seien Hydroxyphenylketone, Benzilketale, Benzoinether, Monoacylphosphinoxide, Bisacylphosphinoxide und α-Diketone genannt. Bevorzugt werden Hydroxyphenylketone eingesetzt, besonders bevorzugt ist 2-Hydroxy-2,2-dimethylacetophenon. Typische Vertreter dieser Verbindungen sind im Handel unter den Bezeichnungen "Irgacure" und "Darocure" (Hersteller: Ciba-Geigy) oder unter der Bezeichnung "Lucirin" (Hersteller: BASF) erhältlich. Vorzugsweise absorbiert der Photoinitiator für die radikalische Polymerisation Licht im Bereich einer Wellenlänge von 320 - 500 nm.

Anstelle eines unter Lichteinwirkung Radikale bildenden Photoinitiators kann ein Photosensibilisierungsmittel für Diaryliodoniumsalze eingesetzt werden, um eine photochemische Aushärtung der Massen mit Strahlung einer längeren Wellenlänge, als sie UVC-Strahlung besitzt, zu erreichen. Beispiele für geeignete Photosensibilisierungsmittel sind Anthracen, Perylen, Phenothiazin, Xanthon und Thioxanthon. Darüber hinaus sind alle Substanzen brauchbar, die nach photochemischer Anregung genügend Energie auf das Diaryliodoniumsalz übertragen können, um einen Zerfall dieses Salzes herbeizuführen. Die Menge des Bestandteils (E) liegt im Bereich von 0,001 - 10%, bezogen auf die Gesamtmasse.

Als Modifikatoren (Bestandteil (F)) können Füllstoffe, beispielsweise Quarzmehl, Silikate, Glasmehl, sowie Farbstoffe und Pigmente, beispielsweise Metallpulver oder Keramikpulver, Stabilisatoren, wie z.B. gehinderte Phenole und gehinderte Amine, Phosphite und Thioether oder Triazine als Radikalfänger, aber auch schwach basische Substanzen, z.B. Amine oder Carboxylate als Säurefänger, sowie Thixotropiermittel und Verdickungsmittel eingesetzt werden. Als weitere Modifikatorengruppen können Initiatoren, Fließverbesserer und Verdünnungsmittel, allein oder in Kombination untereinander oder in Kombination mit den vorstehend genannten Modifikatoren den erfindungsgemäßen Massen zugesetzt werden.

Vorteilhafte Ausführungsformen des erfindungsgemäßen Verfahrens sind dadurch gekennzeichnet, daß eine vollständige thermische Aushärtung der Polymermassen bei 120 °C innerhalb von höchstens 15 Minuten erfolgt, bzw. dadurch, daß eine vollständige thermische Aushärtung der Polymermassen bei 110 °C in weniger als 5 Minuten erfolgt. Die Erfindung umfaßt aber auch solche Verfahren, bei denen die thermische Aushärtung länger als 15 Minuten dauert, dann allerdings in jedem Falle bei niedrigeren Temperaturen als 120 °C, beispielsweise bei einer Temperatur zwischen 80 und 100 °C.

Erfindungsgemäß besonders bevorzugt ist ein Verfahren zur Aushärtung einer polymeren Klebe-, Gieß-, Dicht- oder Beschichtungs-Masse in abgeschatteten, strahlungsunzugänglichen Zonen, bei dem die lichtzugänglichen Bereiche einer kationisch härtenden Einkomponenten-Masse gemäß der Erfindung zuerst mit Licht einer Wellenlänge von 200 - 600 nm bestrahlt bzw. solchem Licht ausgesetzt werden und danach zur Aushärtung der strahlungsunzugänglichen Schattenzonen die gesamte Masse auf höchstens 120 °C erwärmt wird.

Die beschriebenen Massen zeichnen sich durch eine sehr gute Lagerstabilität von beispielsweise mehreren Monaten bei einer Temperatur zwischen 4 und 8 °C bzw. von mehreren Wochen bei Raumtemperatur aus. Gleichzeitig besitzen die erfindungsgemäßen Massen niedrige Aushärtetemperaturen und kurze Aushärtezeiten, beispielsweise 2 Minuten bei 110 °C. Gegenüber den bekannten Massen des Standes der Technik konnte die Differenz zwischen der Lagertemperatur und der Aushärtetemperatur verringert werden. Dies vereinfacht den Einsatz der erfindungsgemäßen Massen in technischen Prozessen, bei denen eine Tieftemperaturlagerung der Massen unerwünscht ist und gleichzeitig kurze Aushärtezeiten und niedrige Aushärtetemperaturen gefordert werden. Sowohl der Energieverbrauch als auch die benötigte Zeit für den Fügeprozeß gestalten sich somit erfindungsgemäß günstiger.

Bei einer bevorzugten Verwendung der erfindungsgemäßen Massen wird durch Bestrahlung mit Licht einer Wellenlänge von zwischen 200 und 600 nm eine schnelle Oberflächenhärtung und Fixierung der zu verklebenden oder zu vergießenden Fügeteile erreicht und anschließend wird die in Schattenzonen als Flüssigkeit verbliebene Masse mittels Erwärmung ausgehärtet. Dabei ist es unerheblich, auf welche Art und Weise die Massen erhitzt und die Aushärtetemperaturen erreicht werden. Neben üblichen Wärmeöfen sind beispielsweise auch Infrarotstrahlung oder Mikrowellen zur Aufheizung geeignet.

Die Erfindung wird anhand der folgenden, nicht einschränkenden Beispiele erläutert:

### Beispiel 1

Die in Tabelle 1 aufgeführten Peroxide werden zu einem Reaktionsgemisch gegeben, welches aus folgenden Bestandteilen zusammengesetzt ist:
54,1 % eines cycloaliphatischen Diepoxidharzes (Uvacure 1500 von UCB), 0,3 % eines Diaryliodoniumsalzes (Rhodorsil Photoinitiator 2074 von Rhone-Poulenc), 45,5 % hydroxygruppenhaltiger Verbindungen (43% Tone 305 von Union Carbide und 2,5 % Diol 6000 der Firma ESPE), 0,09% eines radikalischen Photoinitiators (Darocure 1173 von Ciba-Geigy) sowie 0,01% eines Stabilisators auf Phenolbasis (Ralox BHT von Raschig). Die Komponenten werden auf einem Dissolver vermischt, wobei nach Zugabe des Photoinitiators Darocure 1173 unter Ausschluß von Licht mit einer Wellenlänge kleiner 600 nm gearbeitet werden muß. Die Aufbewahrung erfolgt in lichtundurchlässigen Gebinden.

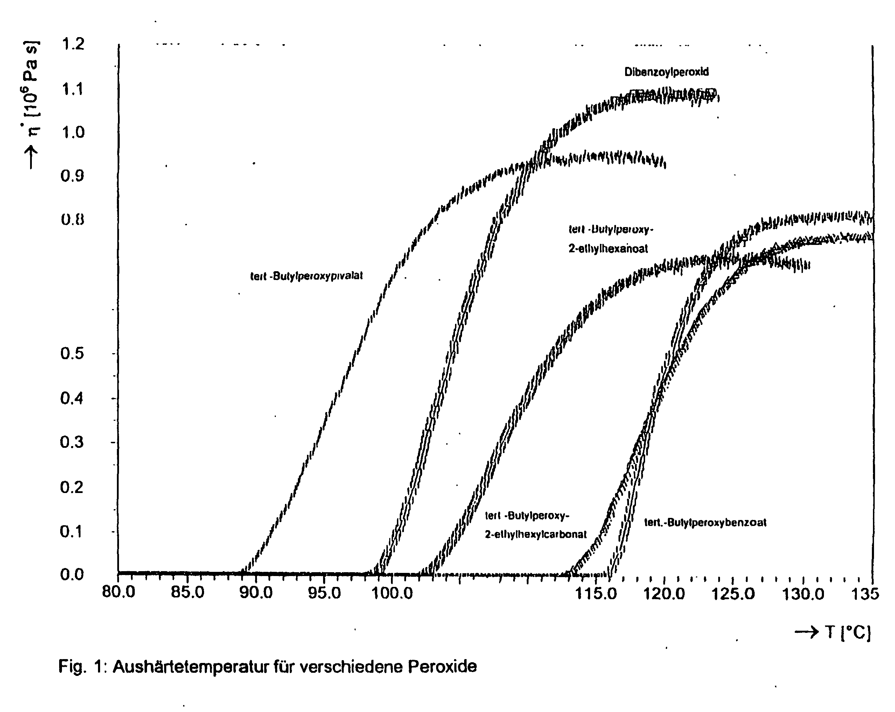

Um die Aushärtetemperatur in Abhängigkeit des zugesetzten Peroxids zu bestimmen, wird mit Hilfe eines Rheometers der Firma Bohlin Instruments (INT CVO 75) die Änderung der Viskosität bei einer definierten Temperaturerhöhung von 2°C pro Minute ermittelt. Die kationisch härtende Masse wird dazu zwischen zwei Platten (Durchmesser der oberen Platte 9 mm) mit einem Spalt von 0,1 mm aufgetragen. Meßgröße ist die komplexe Viskosität η*, gemessen in MPas, die man im Oszillationsmodus des Rheometers bestimmt. Die Temperatur T, bei der die Viskosität ansteigt, wird als Aushärtetemperatur festgelegt. Diese Temperatur kann im Anwendungsfall noch unterschritten werden, da die Polymerisation mit einer gewissen zeitlichen Verzögerung auftritt (siehe auch Beispiele 2 und 3). Während dieser Verzögerung ist aufgrund des verwendeten Temperaturgradienten bereits eine höhere Temperatur erreicht, als tatsächlich für den Beginn der Polymerisation notwendig ist. Figur 1 zeigt den mittels Rheometer bestimmten Aushärteverlauf des Reaktionsgemisches für die verschiedenen Peroxide in Abhängigkeit von der Temperatur.

Um Aussagen über die Lagerstabilität treffen zu können, werden mittels Rheometer sowohl die Grundviskosität als auch die Reaktivität der jeweiligen Mischungen im Abstand eines Monats überprüft. Die in Tabelle 1 angegebenen Lagerstabilitäten verstehen sich als Minimalwerte, da zusätzlich noch Stabilisatoren für die kationische Polymerisation, z. B. Aminverbindungen, den Ansätzen zugefügt werden können.

**Tabelle 1:**

| Aushärtetemperaturen bei Verwendung verschiedener Peroxide | | | | | |
|---|---|---|---|---|---|
| Peroxid | Hersteller | Gew.-% Peroxid | Gew.-% Reaktionsgemisch | Aushärtetemperatur | Lagerstabilität bei 8°C |
| tert.-Butylperoxypivalat, Lösung 75% in Aliphaten | Peroxid-Chemie | 0,7 | 99,3 | 90°C | 3 Monate |
| Dibenzoylperoxid, phlegmatisiert | Pergan | 1,0 | 99,0 | 100°C | 6 Monate |
| tert.-Butylperoxy-2-ethylhexanoat | Peroxid-Chemie | 0,5 | 99,5 | 104°C | 6 Monate |
| tert.-Butylperoxy-2-ethylhexylcarbonat | Pergan | 0,5 | 99,5 | 114°C | 9 Monate |
| tert.-Butylperoxybenzoat | Peroxid-Chemie | 0,5 | 99,5 | 117°C | 9 Monate |

### Beispiel 2

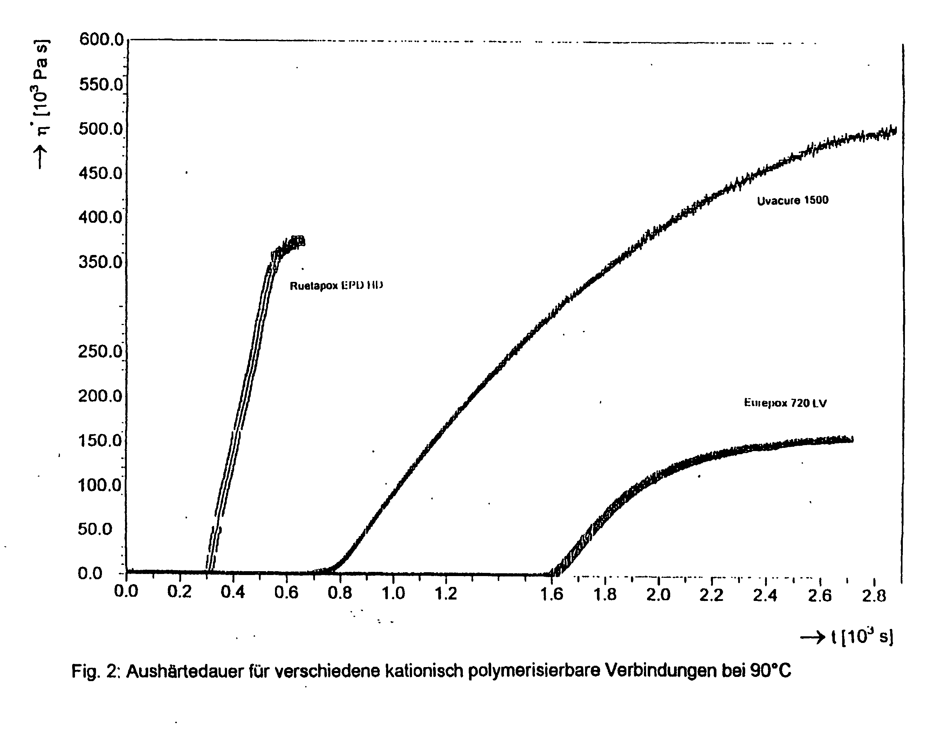

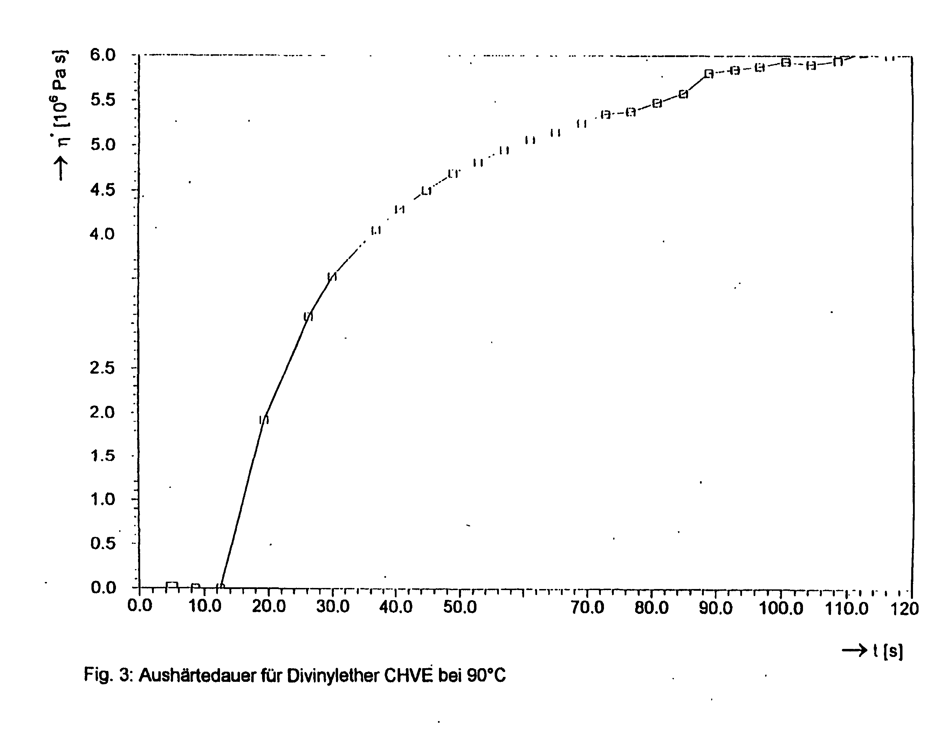

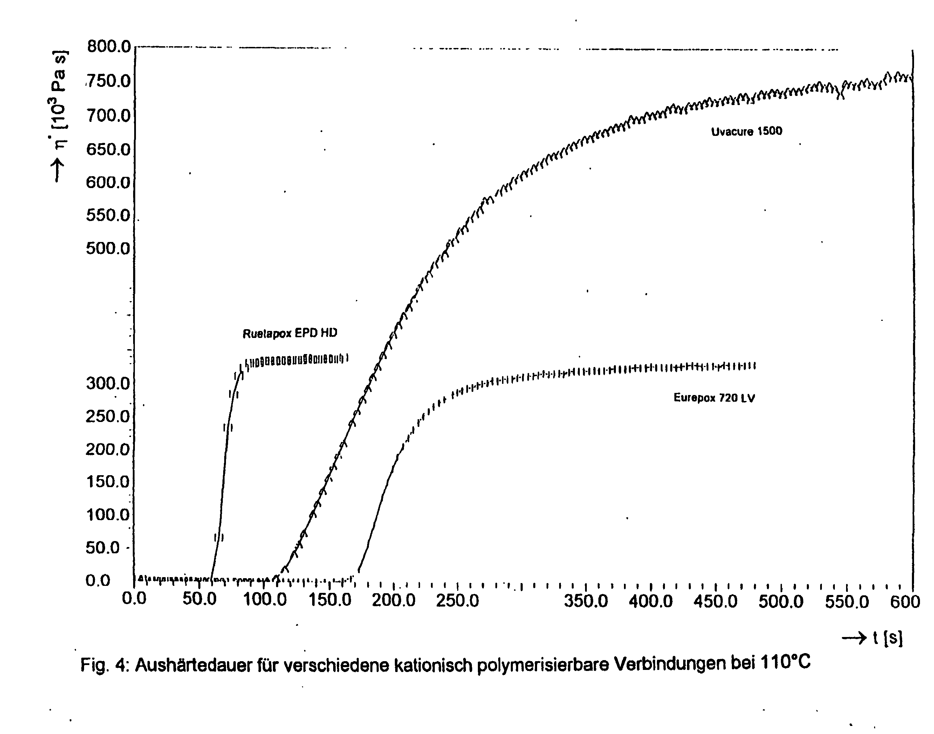

Um die maximale Aushärtedauer zu ermitteln, werden warmhärtende Massen mit unterschiedlichen kationisch polymerisierbaren Harzen isotherm am Rheometer ausgehärtet. Bestandteile dieser Massen sind: 53,4 % (difunktionelles Epoxidharz) bzw. 96,4 % (Divinylether) einer kationisch polymerisierbaren Verbindung entsprechend Tabelle 2, 0,3 % eines Diaryliodoniumsalzes (Rhodorsil Photoinitiator 2074 von Rhone-Poulenc), 45,5 % hydroxygruppenhaltiger Verbindungen (43% Tone 305 von Union Carbide, 2,5 % Diol 6000 der Firma ESPE) bzw. im Falle von Divinylether als kationisch polymerisierbare Verbindung 2,5% einer hydroxygruppenhaltigen Verbindung (Diol 6000 der Firma ESPE), 0,7 % tert.-Butylperoxypivalat, Lösung 75% in Aliphaten der Peroxid-Chemie, 0,09% eines radikalischen Photoinitiators (Darocure 1173 von Ciba-Geigy) sowie 0,0 1 % eines Stabilisators auf Phenolbasis (Ralox BHT von Raschig). Die Verarbeitung entspricht der von Beispiel 1.
In Tabelle 2 sind die verwendeten kationisch polymerisierbaren Harze und die erzielbaren Aushärtezeiten aufgelistet. Als Aushärtedauer wird der Zeitpunkt definiert, an dem 90 % des Plateauwerts der Viskosität erreicht ist. Die Figuren 2 bis 4 zeigen die dazugehörigen, am Rheometer gemessenen Aushärtekurven für 90°C und 110°C.

**Tabelle 2:**

| Aushärtedauer für verschiedene kationisch polymerisierbare Verbindungen | | | |
|---|---|---|---|
| Kationisch polymerisierbares Harz | Hersteller | Aushärtedauer bei 90°C | Aushärtedauer bei 110°C |
| Aromatisches Diepoxidharz Eurepox 720 LV | Witco Surfactants | 40 min | 5 min |
| Cycloaliphatisches Diepoxidharz Uvacure 1500 | UCB | 45 min | 6 min |
| Aliphatisches Diepoxidharz Ruetapox EPD HD | Bakelite AG | 9 min | 80 sec |
| Divinylether CHVE | ISP Europe | 90 sec | Zu reaktiv |

### Beispiel 3

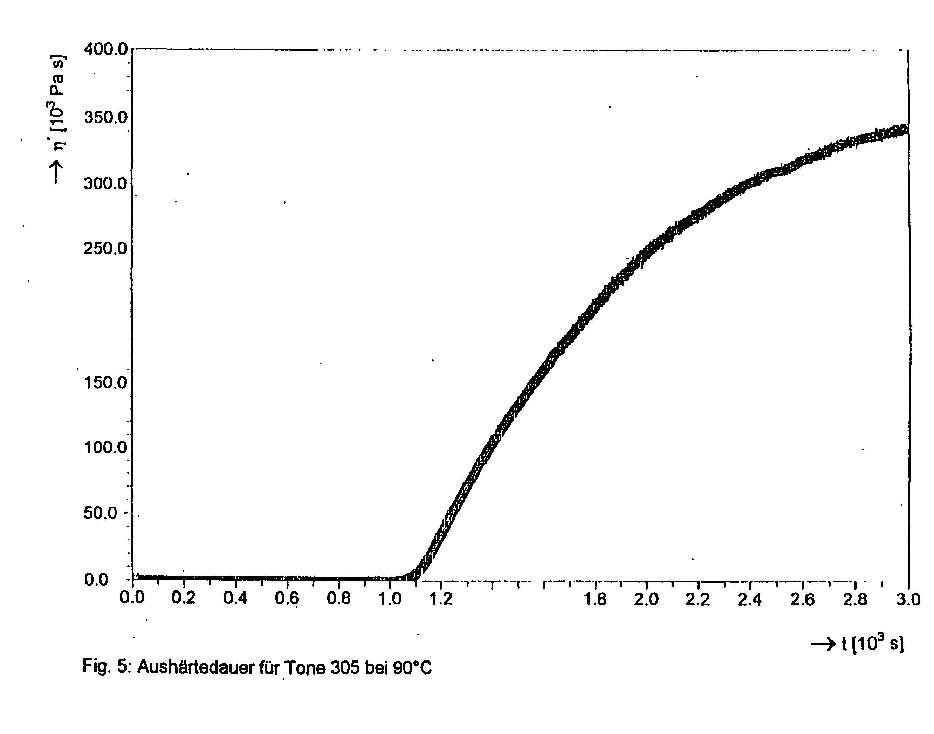

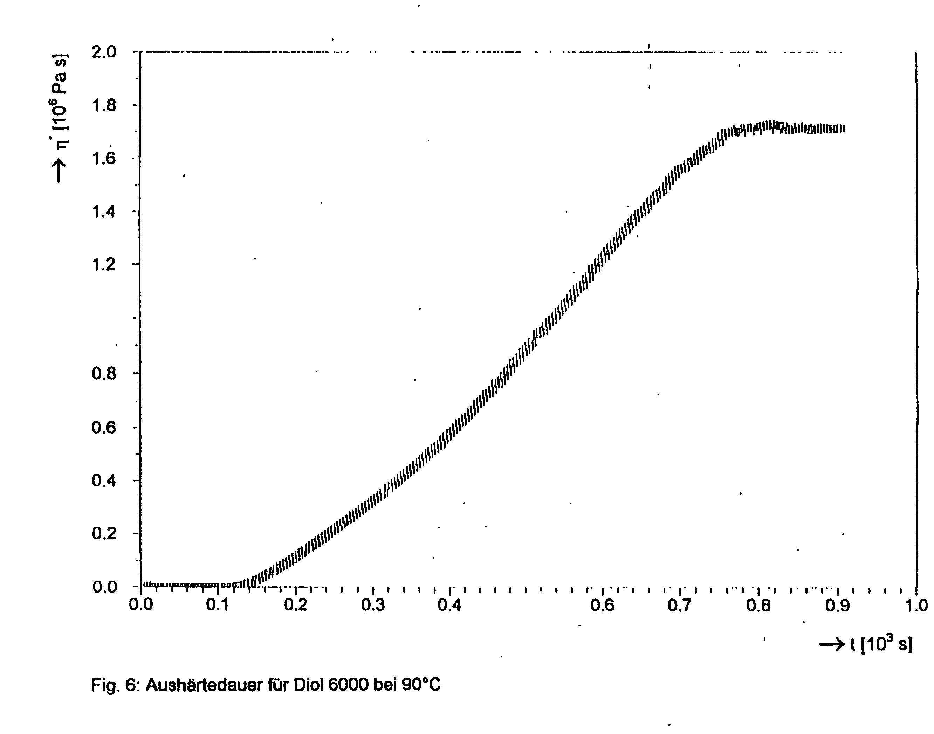

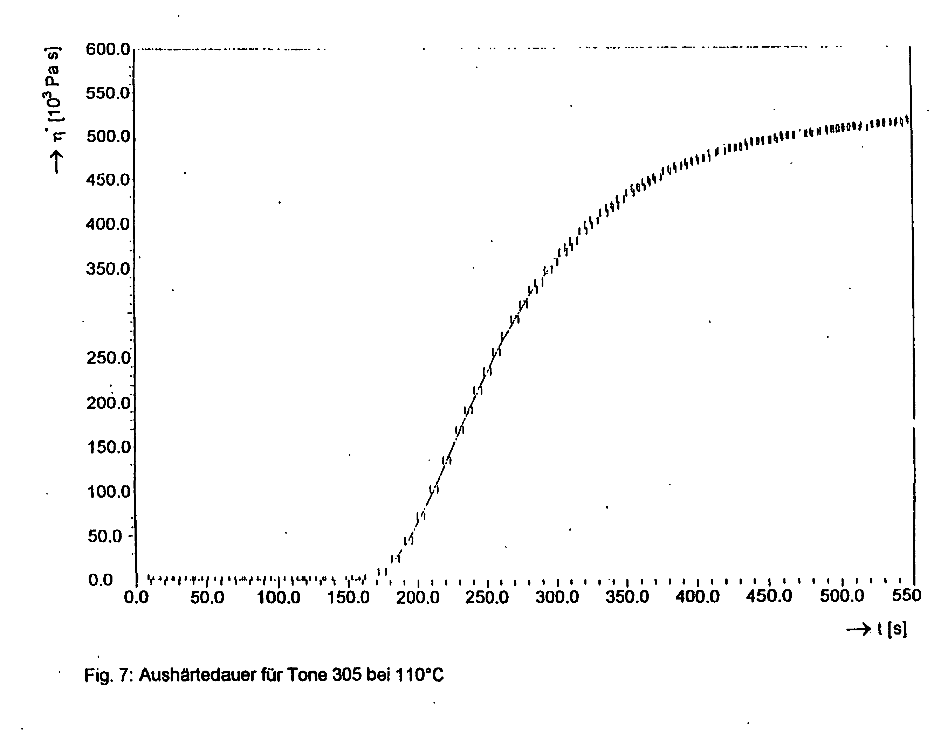

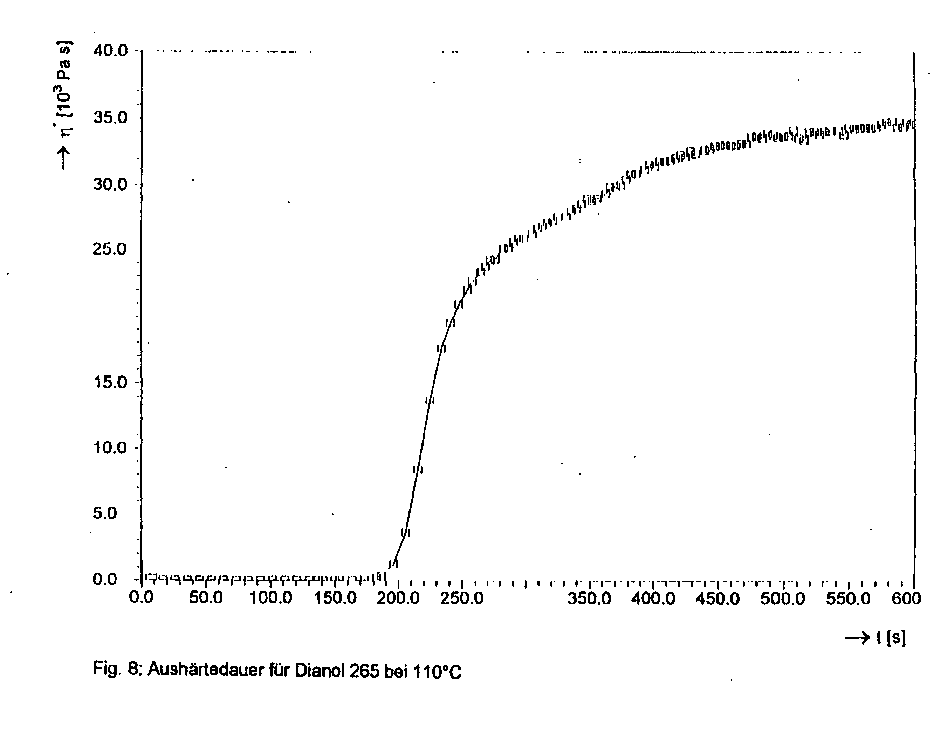

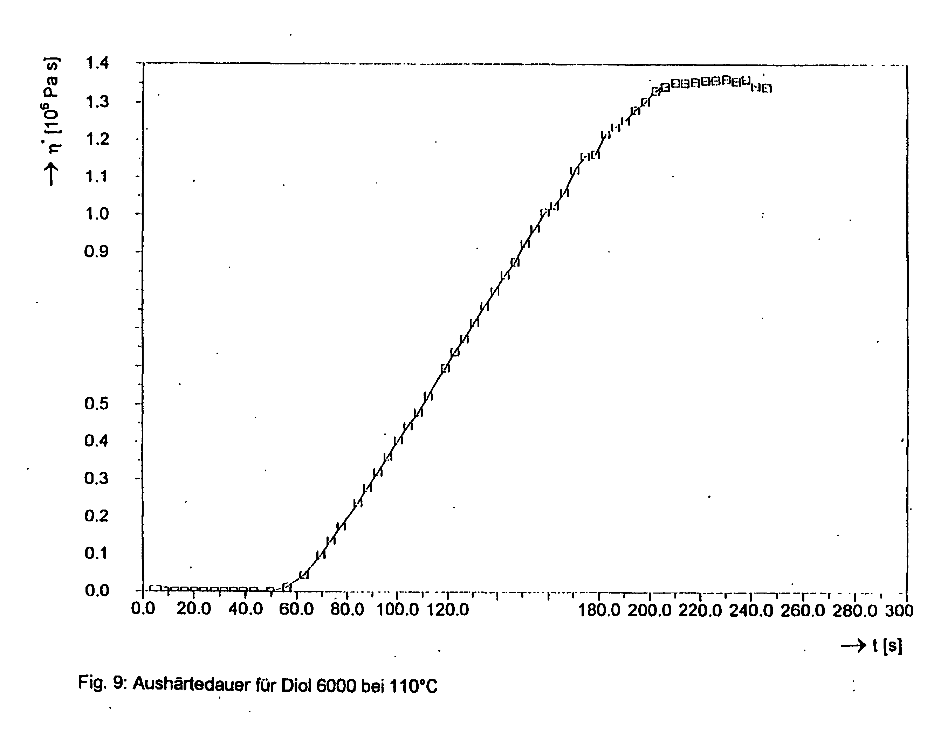

Die Aushärtedauer wird in Abhängigkeit verschiedener hydroxygruppenhaltiger Verbindungen analog zu Beispiel 2 rheometrisch bestimmt. Die kationisch polymerisierbare Masse besteht aus 53,4 % eines cycloaliphatischen Diepoxidharzes (Uvacure 1500 von UCB), 0,3 % eines Diaryliodoniumsalzes (Rhodorsil Photoinitiator 2074 von Rhone-Poulenc), 45,5 % einer hydroxygruppenhaltigen Verbindung entsprechend Tabelle 3, 0,7 % tert.-Butylperoxypivalat, Lösung 75% in Aliphaten der Peroxid-Chemie, 0,09% eines radikalischen Photoinitiators (Darocure 1173 von Ciba-Geigy) sowie 0,01% eines Stabilisators auf Phenolbasis (Ralox BHT von Raschig). Die Verarbeitung entspricht der von Beispiel 1. Die Figuren 5 bis 9 zeigen die dazugehörigen, am Rheometer gemessenen Aushärtekurven für 90°C und 110°C.

**Tabelle 3:**

| Aushärtedauer für verschiedene hydroxygruppenhaltige Verbindungen | | | |
|---|---|---|---|
| Hydroxygruppenhaltige Verbindung | Hersteller | Aushärtedauer bei 90°C | Aushärtedauer bei 110°C |
| Tone 305 | Union Carbide | 45 min | 6 min |
| Dianol 265 | Akzo Nobel | Keine Aushärtung innerhalb 1 h | 7 min |
| Diol 6000 | ESPE | 12 min | 3 min |

### Beispiel 4

Es wurden die Kohäsionen und die Reißdehnungen von unterschiedlich ausgehärteten Prüfkörpern einer kationisch polymerisierbaren Masse entsprechend Beispiel 1 mit 1,0 % Dibenzoylperoxid bestimmt. Folgende Aushärtebedingungen wurden gewählt:
- Lichthärtung, 30 sec unter einer Lampe LUX 03 der Firma DELO (UV-A / VIS-Strahler), Leistung 50 mW/cm²
- Warmhärtung 110°C, 45 min,
- Kombinationen Licht-/Warmhärtung mit den oben genannten Parametern, wobei zwischen den beiden Aushärteverfahren die Prüfkörper zwei Stunden im Dunkeln bei Raumtemperatur gelagert wurden,
- bzw. Kombination Warm-/Lichthärtung, Bedingungen wie oben genannt.

Die Prüfkörper, die nach der Aushärtung 16 Stunden bei Raumtemperatur im Dunkeln gelagert wurden, besitzen einen Querschnitt von 2 x 2 mm und eine Länge zwischen den Halteklammern der Zugprüfmaschine von 20 mm. Gemessen wurde an einer Zugprüfmaschine der Firma Zwick (Zwick 1466) bis zum Materialversagen der Prüfkörper, wobei als Vorschubgeschwindigkeit der Zugscherbelastung 30 mm/min gewählt wurde Die Ergebnisse in Tabelle 4 zeigen, daß der Aushärtezustand durch die zuerst gewählte Aushärtevariante bestimmt wird, lediglich in der Kombination Licht / Wärme zeigt sich noch eine geringfügige Abnahme der Reißdehnung. Allgemein erzielt man bei der Warmhärtung um 25-30% geringere Werte für Kohäsion und Reißdehnung.

**Tabelle 4:**

| Kohäsion und Reißdehnung für unterschiedliche Aushärtebedingungen | | |
|---|---|---|
| Aushärtebedingung | Kohäsion in MPa | Reißdehnung in % |
| Licht | 29,8 ± 3,8 | 111,7 ± 12,7 |
| Wärme | 21,8 ± 2,8 | 72,1 ± 9,5 |
| Licht / Wärme | 29,6 ± 3,2 | 99,2 ± 6,4 |
| Wärme / Licht | 21,1 ± 1,5 | 72,7 ± 5,5 |

## Patentansprüche

1. Kationisch härtende Masse, bestehend aus:
(A) 5 - 90 Masseteilen mindestens einer mindestens difunktionellen, kationisch polymerisierbaren Verbindung
(B) 0,01 - 5 Masseteilen eines Photoinitiators für die kationische Härtung auf Basis von Diaryliodoniumsalzen
(C) 0,1 - 70 Masseteilen von mindestens einer hydroxylgruppenhaltigen Verbindung mit einer Molmasse von 150 bis 10.000 g/mol und Hydroxy-Äquivalentmassen von 50 bis 5.000 g/mol
(D) 0,01 - 10 Masseteilen einer bei Erwärmung Radikale freisetzenden Verbindung mit einer Halbwertszeit von einer Stunde bei einer Temperatur von weniger als 100 °C
(E) 0,001 - 10 Masseteilen eines Radikale bildenden Photoinitiators oder eines Photosensibilisierungsmittels für Diaryliodoniumsalze
(F) 0 - 60 Masseteilen von Modifikatoren, ausgewählt aus mindestens einer der Gruppen der Füllstoffe, Farbstoffe, Pigmente, Stabilisatoren, Beschleuniger, Verzögerer, Initiatoren, Fließverbesserer, Thixotropiermittel, Verdünnungsmittel und polymeren Verdickungsmittel,
wobei die Summe aller Masseteile 100 beträgt
und sämtliche Bestandteile (A) bis (F) der kationisch härtenden Masse in Form eines lagerstabilen Einkomponenten-Gemischs vorliegen und wobei die kationisch härtende Masse lichtinitiiert und/oder wärmeinitiiert vollständig aushärtbar ist.

2. Masse nach Anspruch 1, **dadurch gekennzeichnet, daß** mindestens eine der mindestens difunktionellen, kationisch polymerisierbaren Verbindungen ein Diepoxid ist.

3. Masse nach Anspruch 2, **dadurch gekennzeichnet, daß** mindestens eine der mindestens difunktionellen, kationisch polymerisierbaren Verbindungen ein cycloaliphatisches Diepoxid ist.

4. Masse nach Anspruch 3, **dadurch gekennzeichnet, daß** mindestens eine der mindestens difunktionellen, kationisch polymerisierbaren Verbindungen 3,4-Epoxycyclohexylmethyl-3',4'-epoxycyclohexylcarboxylat ist.

5. Masse nach einem der Ansprüche 1 bis 4, **dadurch gekennzeichnet, daß** das Diaryliodoniumsalz ein Anion mit einer geringeren Nucleophilie als SbF₆⁻ enthält.

6. Masse nach einem der Ansprüche 1 bis 5, **dadurch gekennzeichnet, daß** die hydroxylgruppenhaltigen Verbindungen aus der aus Polyesterpolyolen, Polyetherpolyolen, Polycarbonatpolyolen, Polybutadienpolyolen und alkoxyverlängerten Hydroxyaromaten bestehenden Gruppe ausgewählt sind.

7. Masse nach einem der Ansprüche 1 bis 6, **dadurch gekennzeichnet, daß** die bei Erwärmung Radikale freisetzende Verbindung eine Peroxoverbindung ist.

8. Masse nach Anspruch 7, **dadurch gekennzeichnet, daß** die Peroxoverbindung eine Halbwertszeit von einer Stunde bei einer Temperatur von weniger als 80 °C besitzt.

9. Masse nach einem der Ansprüche 1 bis 8, **dadurch gekennzeichnet, daß** der Photoinitiator für die radikalische Polymerisation im Bereich von 320 - 500 nm Wellenlänge Licht absorbiert.

10. Verwendung der kationisch härtenden Massen nach einem der Ansprüche 1 bis 9 für das Verkleben, Vergießen, Abdichten und Beschichten von Substraten.

11. Verwendung nach Anspruch 10 für elektronische Bauteile.

12. Verfahren zur Herstellung kationisch gehärteter Polymermassen, **dadurch gekennzeichnet, daß** eine kationisch härtende Einkomponenten-Masse gemäß einem der Ansprüche 1 bis 9 unter der Einwirkung von Licht einer Wellenlänge von 200 - 600 nm und/oder unter Wärmezufuhr, wobei die kationisch härtende Masse auf höchstens 120°C erwärmt wird, gehärtet wird.

13. Verfahren nach Anspruch 12, **dadurch gekennzeichnet, daß** eine vollständige thermische Aushärtung der Polymermassen bei 120°C innerhalb von höchstens 15 Minuten erfolgt.

14. Verfahren nach Anspruch 12, **dadurch gekennzeichnet, daß** eine vollständige thermische Aushärtung der Polymermassen bei 110°C in weniger als 5 Minuten erfolgt.

15. Verfahren zur Aushärtung einer polymeren Klebe-, Gieß-, Dicht- oder Beschichtungs-Masse in abgeschatteten, strahlungsunzugänglichen Zonen, **dadurch gekennzeichnet, daß** die lichtzugänglichen Bereiche einer kationisch härtenden Einkomponenten-Masse gemäß einem der Ansprüche 1 bis 9 zuerst mit Licht einer Wellenlänge von 200 - 600 nm bestrahlt bzw. solchem Licht ausgesetzt werden und danach zur Aushärtung der strahlungsunzugänglichen Zonen die gesamte Masse auf höchstens 120°C erwärmt wird.

## Claims

1. A cationically hardenable mass, consisting of:
(A) from 5 to 90 parts by mass of at least one at least difunctional cationically polymerizable compound;
(B) from 0.01 to 5 parts by mass of a photo-initiator for the cationic hardening based upon diaryliodonium salts;
(C) from 0.1 to 70 parts by mass of at least one compound containing a hydroxyl group and having a molar mass of from 150 to 10,000 g/mol and hydroxy-equivalent masses of from 50 to 5,000 g/mol;
(D) from 0.01 to 10 parts by mass of a compound releasing radicals when heated and having a half-life of one hour at a temperature of less than 100°C;
(E) from 0.001 to 10 parts by mass of a photo-initiator forming radicals or of a photo-sensitizing agent for diaryliodonium salts, and
(F) from 0 to 60 parts by mass of modifiers, selected from at least one of the groups of fillers, dyes, pigments, stabilizers, accelerators, retardants, initiators, flow promoters, thixotropic agents, diluents and polymeric thickening agents,
with the sum of all the parts by mass amounting to 100 and all the constituents (A) to (F) of the cationically hardening mass being present in the form of a single-component mixture capable of being stored in a stable manner and with the cationically hardening mass being completely hardenable when light-initiated and/or heat-initiated.

2. The mass of Claim 1, **characterized in that** at least one of the at least difunctional cationically polymerizable compounds is a diepoxide.

3. The mass of Claim 2, **characterized in that** at least one of the at least difunctional cationically polymerizable compounds is a cycloaliphatic diepoxide.

4. The mass of Claim 3, **characterized in that** at least one of the at least difunctional cationically polymerizable compounds is 3,4-epoxycyclohexylmethyl-3',4'-epoxycyclohexylcarboxylate.

5. The mass of one of Claims 1 to 4, **characterized in that** the diaryliodonium salt contains an anion having a nucleophilicity lower than SbF₆⁻.

6. The mass of one of Claims 1 to 5, **characterized in that** the compounds containing hydroxyl groups are selected from the group consisting of polyester polyols, polyether polyols, polycarbonate polyols, polybutadiene polyols and alkoxy-extended hydroxy aromatic compounds.

7. The mass of one of Claims 1 to 6, **characterized in that** the compound which releases radicals when heated is a peroxo compound.

8. The mass of Claim 7, **characterized in that** the peroxo compound has a half-life of one hour at a temperature of less than 80°C.

9. The mass of one of Claims 1 to 8, **characterized in that** the photo-initiator for the radical polymerization absorbs light in the range of a wavelength of from 320 to 500 nm.

10. Use of the cationically hardening masses according to one of Claims 1 to 9 for bonding, casting, sealing and coating of substrates.

11. The use of Claim 10 for electronic components.

12. A process for preparing cationically hardened polymer masses, **characterized in that** a cationically hardening single-component mass according to one of Claims 1 to 9 is hardened under the action of light of a wavelength of from 200 to 600 nm and/or with the application of heat, with said cationically hardening mass being heated to at most 120°C.

13. The process of Claim 12, **characterized in that** a complete thermal hardening of the polymer masses takes place within at most 15 minutes at 120°C.

14. The process of Claim 12, **characterized in that** a complete thermal hardening of the polymer masses takes place in less than 5 minutes at 110°C.

15. A process for hardening a polymeric adhesive, casting, sealing or coating mass in shadowed zones inaccessible to radiation, **characterized in that** the light-accessible areas of a cationically hardening single-component mass according to one of Claims 1 to 9 are first irradiated with light of a wavelength of from 200 to 600 nm or are exposed to such a light, and after that the entire mass is heated to at most 120°C in order to harden the zones inaccessible to radiation.

## Revendications

1. Masse apte au durcissement cationique, consistant en :
(A) 5 à 90 parties en poids d'au moins un composé au moins difonctionnel, apte à la polymérisation cationique,
(B) 0,01 à 5 parties en poids d'un photo-inducteur du durcissement. cationique, à base de sels de diaryliodonium,
(C) 0,1 à 70 parties en poids d'au moins un composé contenant des groupes hydroxy, à une masse moléculaire de 150 à 10000 g/mol et un poids équivalent des groupes hydroxy de 50 à 5000 g/mol,
(D) 0,01 à 10 parties en poids d'un composé libérant des radicaux au chauffage, ayant une période d'une heure à une température inférieure à 100°C,
(E) 0,01 à 10 parties en poids d'un photo-inducteur formant des radicaux libres ou d'un agent photosensibilisant pour les sels de diaryliodonium,
(F) 0 à 60 parties en poids d'agents modifiants choisis dans au moins un des groupes suivants : matières de charge, colorants, pigments, stabilisants, accélérateurs, retardateurs, inducteurs, fluidifiants, agents thixotropiques, diluants et agents épaississants polymères,
la somme de toutes les parties en poids étant de 100,
et tous les constituants (A) à (F) de la masse apte au durcissement cationique étant à l'état de mélange à un composant, stable à la conservation, la masse apte au durcissement cationique étant totalement durcissable par induction à la lumière et/ou à la chaleur.

2. Masse selon la revendication 1, **caractérisée en ce qu'**au moins un des composés au moins bifonctionnels aptes à la polymérisation cationique consiste en un diépoxyde.

3. Masse selon la revendication 2, **caractérisée en ce qu'**au moins un des composés au moins difonctionnels aptes à la polymérisation cationique est un diépoxyde cycloaliphatique.

4. Masse selon la revendication 3, **caractérisée en ce qu'**au moins un des composés au moins difonctionnels aptes à la polymérisation cationique consiste en le 3',4'-époxycyclohexylcarboxylate de 3,4-époxycyclohexylméthyle.

5. Masse selon l'une des revendications 1 à 4, **caractérisée en ce que** le sel de diaryliodonium contient un anion à nucléophilie plus faible que SbF₆⁻.

6. Masse selon l'une des revendications 1 à 5, **caractérisée en ce que** les composés contenant des groupes hydroxy sont choisis dans le groupe des polyester-polyols, des polyéther-polyols, des polycarbonate-polyols, des polybutadiène-polyols et des dérivés hydroxyaromatiques allongés par des groupes alcoxy.

7. Masse selon l'une des revendications 1 à 6, **caractérisée en ce que** le composé libérant des radicaux au chauffage est un composé en peroxo.

8. Masse selon la revendication 7, **caractérisée en ce que** le composé en peroxo a une période d'une heure à une température inférieure à 80°C.

9. Masse selon l'une des revendications 1 à 8, **caractérisée en ce que** le photo-inducteur de la polymérisation radicalaire absorbe la lumière dans l'intervalle des longueurs d'ondes de 320 à 500 nm.

10. Utilisation des masses aptes au durcissement cationique selon l'une des revendications 1 à 9 pour des collages, des moulages par coulée, des étanchéités et des revêtements de supports.

11. Utilisation selon la revendication 10 pour des pièces de construction électroniques.

12. Procédé pour la préparation de masses polymères durcies par durcissement cationique **caractérisé en ce que** l'on durcit une masse à un composant apte au durcissement cationique selon une des revendications 1 à 9 sous l'action de la lumière à une longueur d'ondes de 200 à 600 nm et/ou par apport de chaleur, la masse apte au durcissement cationique étant chauffée à 120°C au maximum.

13. Procédé selon la revendication 12, **caractérisé en ce que** le durcissement thermique complet de la masse polymère à 120°C demande 15 minutes au maximum.

14. Procédé selon la revendication 12, **caractérisé en ce que** le durcissement thermique complet de la masse polymère à 110°C demande moins de 5 minutes.

15. Procédé pour durcir une masse polymère de collage, à couler, d'étanchéité ou de revêtement dans des zones ombragées inaccessibles à tout rayonnement, **caractérisé en ce que** l'on irradie d'abord les régions accessibles à la lumière d'une masse à un composant apte au durcissement cationique selon l'une des revendications 1 à 9 par de la lumière à une longueur d'ondes de 200 à 600 nm ou bien on les expose à une telle lumière puis, pour durcir les régions inaccessibles au rayonnement, on chauffe toute la masse à une température maximale de 120°C.
